# EUROPÄISCHE PATENTSCHRIFT

(11) **EP 0 926 937 B1**
(45) Veröffentlichungstag und Bekanntmachung des Hinweises auf die Patenterteilung: **08.05.2002**
(21) Anmeldenummer: 98123290.3
(22) Anmeldetag: 07.12.1998
(51) Int. Cl.: H05K 7/14

(54) **Baugruppenrahmen zur Aufnahme von unterschiedlichen Baugruppen**
Component rack for differing component cards
Chassis de montage de sous-ensembles différents

(30) Priorität: 16.12.1997 DE 19755943
(43) Veröffentlichungstag der Anmeldung: 30.06.1999
(73) Patentinhaber: SIEMENS AKTIENGESELLSCHAFT, 80333 München (DE)
(72) Erfinder: Gerlich, Walter, 86179 Augsburg (DE); Siebold, Carsten, 82205 Gilching (DE); Duerr, Martin, 85221 Dachau (DE)

(56) Entgegenhaltungen:
- EP-A- 0 438 012

## Beschreibung

Die vorliegende Erfindung betrifft einen Baugruppenrahmen zur Aufnahme von unterschiedlichen Baugruppen, die sowohl von vorne als auch von hinten in den Baugruppenrahmen einschiebbar sind und wobei die einzelnen Baugruppen über eine innerhalb des Baugruppenrahmens im mittleren Bereich senkrecht angeordnete Backplane elektrisch miteinander verbunden sind, siehe beispielsweise die EP-A-0 438 012.

Bei Baugruppenrahmen, die durch ihren Aufbau bedingt, eine zum Baugruppenrahmen mittig angeordnete Blackplane benötigen, ist ein Einbau an dieser unzugänglichen Stelle nur schwer möglich. Aus Platz- und Kostengründen werden solche Geräte möglichst klein gebaut, was die Problematik noch verstärkt. Diese Baugruppenrahmen benötigen ausserdem aus schirmungstechnischen und elektrostatischen Gründen eine sichere Massenkontaktierung.

Derzeit sind zwei Methoden bekannt, die Blackplane bei derartigen Baugruppenrahmen einzubauen. Die erste Methode besteht darin, daß um die Backplane leicht zugänglich zu machen, der Baugruppenrahmen in der Einbauebene der Backplane getrennt wird. Dies bedeutet einen deutlichen konstruktiven Mehraufwand durch zusätzliche Befestigungs- und Schirmungsteile. Zudem ist eine solche Teilung nicht immer möglich. Die zweite Methode besteht darin, daß in den Fällen, in welchen die Trennung des Baugruppenrahmens aus konstruktiven, schirmungstechnischen oder fertigungstechnischen Gründen nicht durchführbar ist, die Backplane mittels Schrauben befestigt wird. Bedingt durch den vertieften Einbauort ist dies in der Großserienfertigung mit üblichen Fertigungswerkzeugen nur schwer und kostenintensiv machbar.

Aufgabe der vorliegenden Erfindung ist es daher einen Baugruppenrahmen der eingangs genannten Art anzugeben, bei welchem eine mittig angeordnete Backplane leicht montierbar ist.

Diese Aufgabe wird erfindungsgemäß dadurch gelöst, daß die Backplane aus einem im wesentlichen u-förmigen Backplaneträger und einer darauf montierten eigentlichen Backplanebaugruppe besteht, daß der Baugruppenrahmen im mittleren Bereich sowohl in seinem Deckelteil als auch in seinem Bodenteil erste als Drehachse dienende Erhebungen aufweist, welche in an einer Seite des Backplaneträgers oben und unten in den waagerecht verlaufenden Randkanten vorgesehene zur Seite hin offene Ausschnitte einschiebbar sind, daß der Baugruppenrahmen im mittleren Bereich sowohl im Deckelteil als auch im Bodenteil zweite Erhebungen aufweist, welche beim Drehen des Backplaneträgers um die Drehachse als Tiefenanschlag funktionieren.

Bei dem erfindungsgemäßen Baugruppenrahmen wird die mittig einzubauende Backplane an einem leicht zugänglichen Arbeitsplatz vormontiert. Dann wird die Backplane in die Drehachse eingeschoben, und anschließend gedreht, wobei sie gegen den Tiefenanschlag geschwenkt wird. In dieser Position wird sie durch eine Schnappverbindung schraubenlos gehalten. Bei dem erfindungsgemäßen Baugruppenrahmen ist also ein einfacher und schneller Einbau der Backplane durchführbar.

Weitere zweckmäßige Ausgestaltungen der vorliegenden Erfindung ergeben sich aus den Unteransprüchen sowie aus der nachfolgenden Beschreibung eines in der Zeichnung dargestellten Ausführungsbeispiels eines erfindungsgemäßen Baugruppenrahmens.

Es zeigen
Figur 1 eine perspektivische Ansicht eines erfindungsgemäßen Baugruppenrahmens mit einer teilweise schräg eingeschobenen Backplane,

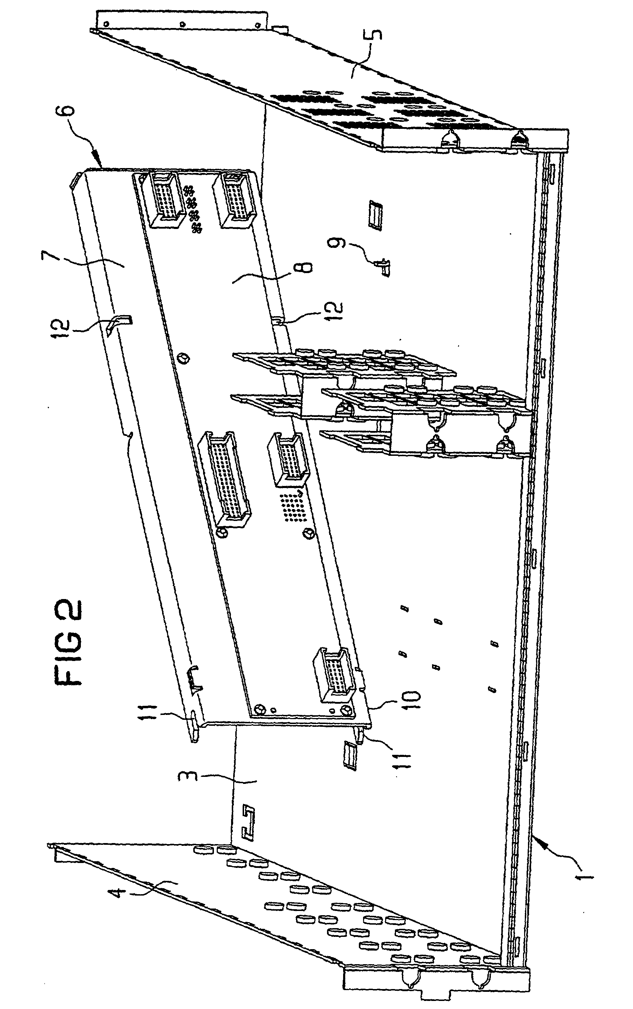

Figur 2 eine perspektivische Ansicht des in Figur 1 gezeigten Baugruppenrahmens mit einer in die Drehachse eingeschobenen Backplane, wobei das Deckelteil zur Erhöhung der Übersichtlichkeit fortgelassen worden ist, und

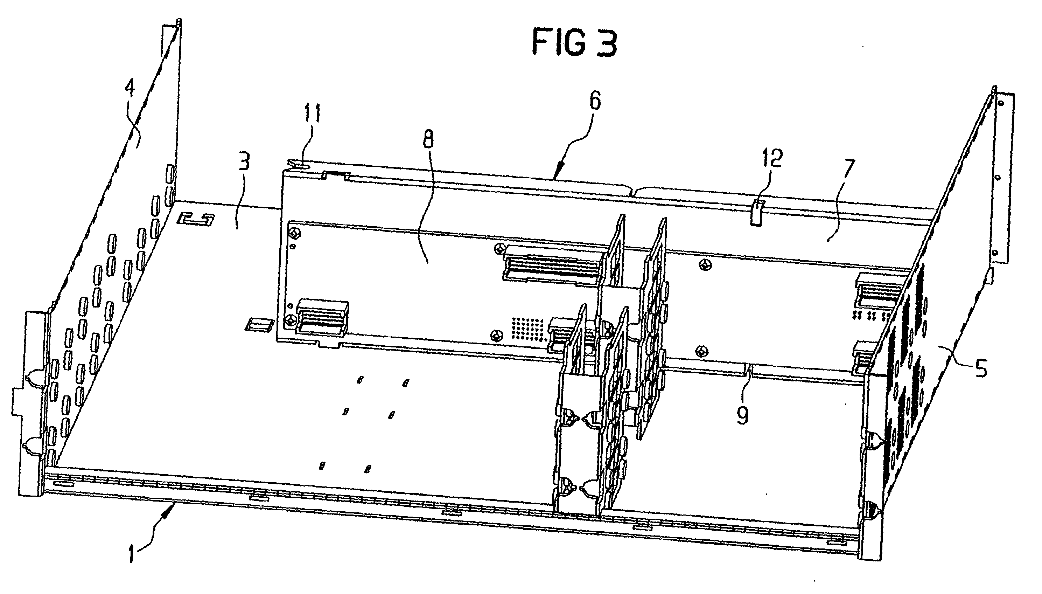

Figur 3 eine perspektivische Ansicht des in Figur 1 dargestellten Baugruppenrahmens mit abgenommenen Deckelteil und einer in die Endlage eingeschwenkten Backplane.

Der Baugruppenrahmen 1 besteht im wesentlichen aus einem Dekkelteil 2, einem Bodenteil 3, einem ersten Seitenteil 4 und einem zweiten Seitenteil 5. In diesen Baugruppenrahmen sollen sowohl von vorne als auch von hinten nicht dargestellte Baugruppen unterschiedlicher Größe und Bauart eingeschoben werden. Diese sollen durch eine mittig montierte Backplane 6 miteinander verbunden werden. Diese Backplane 6 besteht im wesentlichen aus einem Backplaneträger 7 und der eigentlichen Backplanebaugruppe 8, welche die notwendigen Steckvorrichtungen sowie die elektrischen Verbindungen zwischen diesen Steckvorrichtungen aufweist.

Der Backplaneträger 7 ist im wesentlichen u-förmig ausgebildet und besteht im wesentlichen aus einer senkrechten Platte zur Aufnahme der eigentlichen Backplanebaugruppe 8 und aus waagerecht verlaufenden oberen und unteren Randkanten. Jeweils an einer Seite der waagerecht verlaufenden Randkanten sind Ausschnitte 11 vorgesehen, welche zur Stirnseite der Backplane 6 hin offen sind.

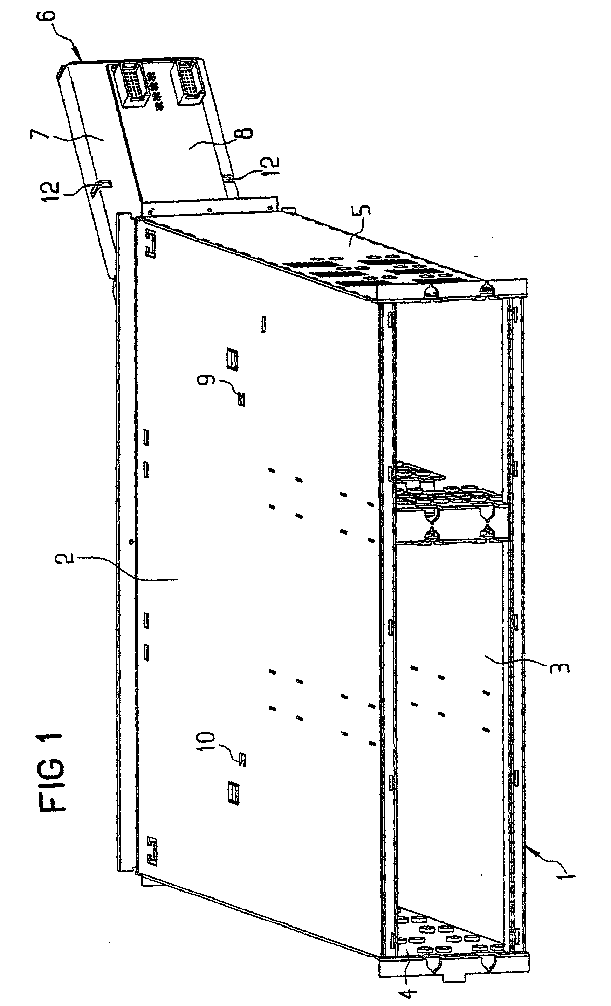

Im Deckelteil 2 sowie im Bodenteil 3 des in der Figur dargestellten Baugruppenrahmens 1 sind erste Erhebungen 9 und zweite Erhebungen 10 vorgesehen. Diese sind, wie besonders in Figur 1 zu erkennen ist, bezüglich der Längsachse des Baugruppenrahmens, welche im rechten Winkel zur Backplane 6 verläuft, symmetrisch angeordnet. Das heißt, jede der Erhebungen kann sowohl als erste Erhebung, welche als Drehachse dient, sowie als zweite Erhebung, welche als Tiefenanschlag funktioniert, verwendet werden. Ein weiterer Vorteil, der sich hieraus ergibt, besteht darin, daß Deckel- und Bodenteil den gleichen Aufbau aufweisen, d. h. austauschbar sind.

Zur Montage der Backplane 6 wird diese schräg in den Baugruppenrahmen 1 eingeführt, so daß ihre Ausschnitte 11 mit den als Drehachse dienenden Erhebungen 10 in Eingriff kommen. Danach wird die Backplane 6 um die durch die Erhebungen 10 ausgebildete Drehachse in den Baugruppenrahmen eingeschwenkt bis die Schwenkbewegung durch die als Tiefenanschlag wirkende Erhebung 9 gestoppt wird. Als Gegenanschlag für die als Tiefenanschlag wirkende Erhebungen 9 weist der Backplaneträger 7 entsprechende Einschnitte 12 auf, deren Abmessungen mit den Ausschnitten 11 übereinstimmen. In der Endlage kann die Backplane mittels einer nicht dargestellten Schnappverbindung schraubenlos in ihrer Endposition gehalten werden.

Die Erhebungen sowohl im Deckelteil 2 als auch im Bodenteil 3 des Baugruppenrahmens 1 sind zweckmäßigerweise als herausgestanzte Blechlappen ausgebildet. Der Backplaneträger 7 kann entweder aus Metall oder aus einem metallisierten Kunststoff bestehen. Weiterhin kann der Backplaneträger 7 bei Bedarf durch zusätzliche Kontaktfedern noch bezüglich seiner elektrischen Leitfähigkeit verbessert werden.

## Patentansprüche

1. Baugruppenrahmen zur Aufnahme von unterschiedlichen Baugruppen, die sowohl von vorne als auch von hinten in den Baugruppenrahmen einschiebbar sind und wobei die einzelnen Baugruppen über eine innerhalb des Baugruppenrahmens im mittleren Bereich senkrecht angeordnete Backplane elektrisch miteinander verbunden sind,
**dadurch gekennzeichnet,**
**daß** die Backplane aus einem im wesentlichen u-förmigen Backplaneträger (7) und einer darauf montierten eigentlichen Backplanebaugruppe (8) besteht,
**daß** der Baugruppenrahmen (1) im mittleren Bereich sowohl in seinem Deckelteil (2) als auch in seinem Bodenteil (3) erste als Drehachse dienende Erhebungen (9) aufweist, welche in an einer Seite des Backplaneträgers (7) oben und unten in den waagerecht verlaufenden Randkanten vorgesehene zur Seite hin offene Ausschnitte (11) einschiebbar sind,
**daß** der Baugruppenrahmen (1) im mittleren Bereich sowohl im Deckelteil (2) als auch im Bodenteil (3) zweite Erhebungen (10) aufweist, welche beim Drehen des Backplaneträgers (7) um die Drehachse als Tiefenanschlag funktionieren.

2. Baugruppenrahmen nach Anspruch 1,
**dadurch gekennzeichnet,**
**daß** der Baugruppenrahmen (1) bezüglich der ersten und zweiten Erhebungen (9, 10) einen symmetrischen Aufbau aufweist.

3. Baugruppenrahmen nach Anspruch 1 oder 2,
**dadurch gekennzeichnet,**
**daß** die Erhebungen (9, 10) sowohl im Deckelteil (2) als auch im Bodenteil (3) als herausgestanzte Blechlappen ausgebildet sind.

4. Baugruppenrahmen nach einem der Ansprüche 1 bis 3,
**dadurch gekennzeichnet,**
**daß** der Backplaneträger (7) aus Metall besteht.

5. Baugruppenrahmen nach einem der Ansprüche 1 bis 3,
**dadurch gekennzeichnet,**
**daß** der Backplaneträger (7) aus metallisiertem Kunststoff besteht.

6. Baugruppenrahmen nach einem der Ansprüche 1 bis 5,
**dadurch gekennzeichnet,**
**daß** die waagerecht verlaufenden Randkanten des Backplaneträgers (7) Kontaktfedern aufweisen.

7. Baugruppenrahmen nach einem der Ansprüche 1 bis 6,
**dadurch gekennzeichnet,**
**daß** der Backplaneträger (7) in seiner Endposition mittels einer Schnappverbindung gesichert ist.

## Claims

1. Module frame for accommodating different modules which can be pushed into the module frame both from the front and from the rear, the individual modules being connected electrically to one another via a backplane arranged vertically in the central region within the module frame, **characterized in that** the backplane comprises an essentially u-shaped backplane support (7) and an actual backplane module (8) fitted thereon, **in that** the module frame (1) has in the central region, both in its cover part (2) and in its base part (3), first elevations (9) which serve as an axis of rotation and can be pushed into cutouts (11) which are provided on one side of the backplane support (7), at the top and bottom, in the horizontally running border edges and are open in the direction of the side, and **in that** the modular frame (1) has in the central region, both in the cover part (2) and in the base part (3), second elevations (10) which, as the backplane support (7) rotates about the axis of rotation, function as a depth stop.

2. Module frame according to Claim 1, **characterized in that** the module frame (1) has a symmetrical construction in relation to the first and second elevations (9, 10).

3. Module frame according to Claim 1 or 2, **characterized in that** the elevations (9, 10) both in the cover part (2) and in the base part (3) are designed as punched-out sheet-metal lugs.

4. Module frame according to one of Claims 1 to 3, **characterized in that** the backplane support (7) consists of metal.

5. Module frame according to one of Claims 1 to 3, **characterized in that** the backplane support (7) consists of metallized plastic.

6. Module frame according to one of Claims 1 to 5, **characterized in that** the horizontally running border edges of the backplane support (7) have contact springs.

7. Module frame according to one of Claims 1 to 6, **characterized in that** the backplane support (7) is secured in its end position by means of a snap-in connection.

## Revendications

1. Châssis de montage de différents sous-ensembles pouvant être insérés dans le châssis de montage aussi bien depuis l'avant que depuis l'arrière, les différents sous-ensembles étant raccordés électriquement entre eux à l'intérieur du châssis de montage par l'intermédiaire d'une plaque arrière placée verticalement dans la partie centrale,
**caractérisé en ce que**
la plaque arrière est constituée d'un porteur de plaque arrière (7) essentiellement en forme de u et d'un sous-ensemble de plaque arrière (8) installé sur le porteur de plaque arrière,
**en ce que** le châssis de montage (1) de sous-ensembles présente dans la partie centrale, aussi bien dans sa partie de couvercle (2) que dans sa partie de fond (3), des premières saillies (9) servant d'axe de rotation, ces saillies étant prévues sur un côté du porteur de plaque arrière (7), en haut et en bas, dans les bords s'étendant horizontalement et étant insérables dans des découpes (11) ouvertes vers le côté,
**en ce que** le châssis de montage (1) de sous-ensembles présente dans la partie centrale, aussi bien dans la partie de couvercle (2) que dans la partie de fond (3), des secondes saillies (10), lesquelles fonctionnent comme butée de profondeur lors de la rotation du porteur de plaque arrière (7) autour de l'axe de rotation.

2. Châssis de montage de sous-ensembles selon la revendication 1,
**caractérisé en ce que**,
le châssis de montage (1) de sous-ensembles présente une construction symétrique en ce qui concerne les premières et les secondes saillies (9, 10).

3. Châssis de montage de sous-ensembles selon la revendication 1 ou 2,
**caractérisé en ce que**
les saillies (9, 10) sont formées comme des pattes en tôle découpée, aussi bien dans la partie de couvercle (2) que dans la partie de fond (3).

4. Châssis de montage de sous-ensembles selon l'une des revendications 1 à 3,
**caractérisé en ce que**
le porteur de plaque arrière (7) est en métal.

5. Châssis de montage de sous-ensembles selon l'une des revendications 1 à 3,
**caractérisé en ce que**
le porteur de plaque arrière (7) est en matière plastique métallisée.

6. Châssis de montage de sous-ensembles selon l'une des revendications 1 à 5,
**caractérisé en ce que**
les bords du porteur de plaque arrière (7) s'étendant horizontalement présentent des ressorts de contact.

7. Châssis de montage de sous-ensembles selon l'une des revendications 1 à 6,
**caractérisé en ce que**
le porteur de plaque arrière (7) est bloqué dans sa position finale au moyen d'un assemblage à encliquetage.
